# EUROPEAN PATENT APPLICATION

(11) **EP 1 661 928 A1**
(43) Date of publication of application: **31.05.2006**
(21) Application number: 05025344.2
(22) Date of filing: 21.11.2005
(51) Int. Cl.: C08F 290/08, C09D 4/06, H01C 1/022, H01G 9/08

(54) **Low temperature snap cure material with suitable worklife**

(30) Priority: 24.11.2004 US 997350
(71) Applicant: National Starch and Chemical Investment Holding Corporation, New Castle, Delaware 19720 (US)
(72) Inventor: Gillissen, Stijn, 3500 Hasselt (BE); Van Wuytswinkel, Grete, 3560 Lummen (BE)
(74) Representative: Held, Stephan

(57) **Abstract**

The present invention discloses a one part, snap curing, acrylic-based composition with long worklife at room temperature. The composition cures in less than 60 seconds at temperatures below 120°C and provides a suitable worklife of 3 days at room temperature. The composition comprise of a radica I initiator with a ten hour half life, 10hr T_{1/2}, equal to or less than 80°C, (meth)acrylate or vinylene-containing base oligomers and at least one additional (meth)acrylate monomer to dilute the base oligomers. Additional ingredients, such as non-reactive chemical compounds, thixotropic agents, pigments, and fillers may be added as desired. A further embodiment of the invention is a method of using the composition with an electronic device.

## Description

### FIELD OF THE INVENTION

The present invention relates to acrylic-based adhesive compositions that rapidly cures at low temperature, nevertheless allows suitable worklife at room temperature.

### BACKGROUND OF THE INVENTION

One and two-part epoxy adhesives are utilized in many microelectronic applications. One component adhesives usually require lengthy cure times. For example, a cure time of over one hour at a temperature in the 120 - 150°C range is common. One-component epoxy materials that are capable of cure at lower temperatures generally require a substantially longer curing time of hours or even days. Because of the ability to cure at low temperatures, such materials must be stored at extremely low temperatures before use. Two component systems in which the epoxy and the hardener are maintained separately until use are also utilized in microelectronic applications. While two component systems are sometimes capable of a quick initial cure, major disadvantages of these systems are that the components must be mixed before use and the worklife is usually very short after mixing. The general limitations of existing epoxy adhesives are that those capable of quick curing require high temperatures to cure, while those capable of curing at low temperatures require a long time period to completely cure. It would be advantageous to provide a one component composition for use with microelectronic devices that are capable of a quick cure at low temperatures.

As the microelectronic industry requires higher throughput, there is an increasing need for fast curing systems at low temperatures and long worklife. Due to the limitations of the current one-part and two-part systems, a novel material that addresses these deficiencies is needed. Hence, there is a need for a one component snap curable material at low temperature with long worklife at room temperature.

### SUMMARY OF THE INVENTION

The present invention discloses a one part, fast-curing, acrylic-based composition which is capable of various uses within microelectronic devices. The composition cures in less than 60 seconds at temperatures below 120°C and provides a suitable worklife. The composition comprise of a radical initiator with a ten hour half life, 10hr T_{½}, equal to or less than 80°C, (meth)acrylate or vinylene-containing base oligomers and at least one additional (meth)acrylate monomer to dilute the base oligomers and/or polymers. Additional ingredients, such as non-reactive chemical compounds, thixotropic agents, pigments, and fillers may be added as desired. A further embodiment of the invention is a method of using the composition with an electronic device.

### BRIEF DESCRIPTION OF THE DRAWING

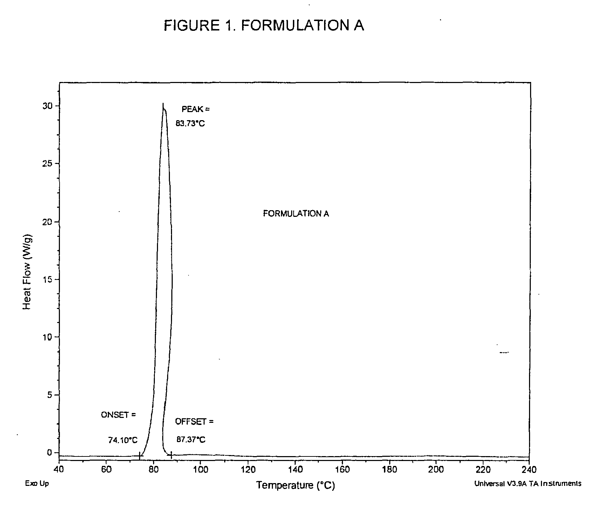

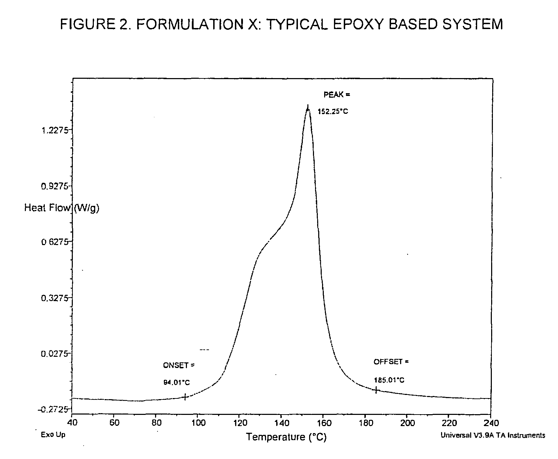

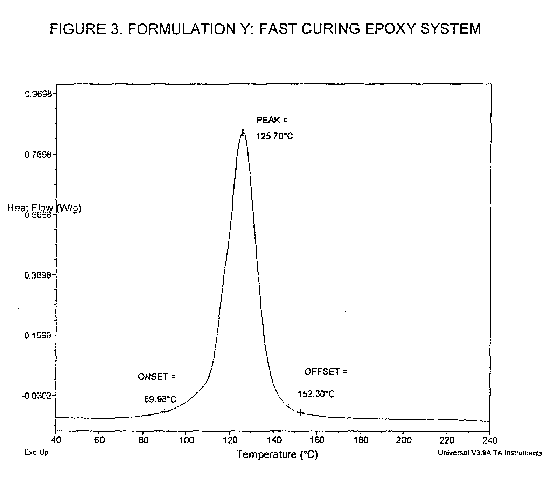

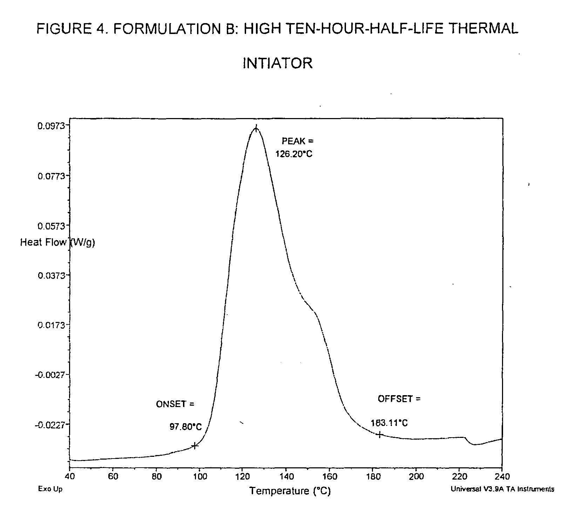

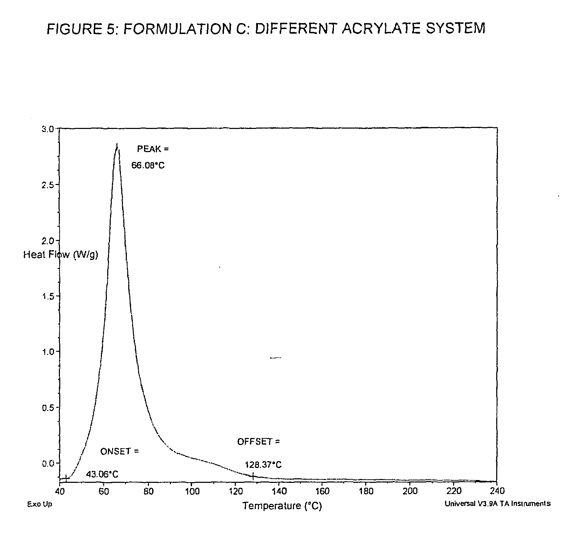

Figure 1 is the DSC curve of a low temperature snap cure material. Figure 2 is the DSC curve of a typical epoxy system. Figure 3 is the DSC curve of a fast curing epoxy system. Figure 4 is the DSC curve of an acrylate system with a radical initiator with 10hr T_{1/2} higher than 80°C. Figure 5 is the DSC curve of a system with a radical initiator with a ten hour half life, 10hr T_{½}, less than 80°C and more reactive acrylate system.

### DETAILED DESCRIPTION OF THE PREFERRED EMBODIEMENTS

The composition of the present invention is an acrylic-based composition that is capable of being snap cured. As used herein, the term snap cure is defined as the ability to cure within 60 seconds of exposure to heat. Depending on the cure method used (effectiveness of heat transfer) the cure time can even be shorter than 10 seconds (= spot curing). While the composition is often characterized as an adhesive throughout the application, it is to be understood that the composition may be utilized as an encapsulant, laminating resin, casting resin, underfill, coating agent and otherwise in microelectronic devices.

The composition comprise one or more of low decomposition temperature thermal initiator, (meth)acrylate or vinylene-containing base oligomers and at least one additional (meth)acrylate monomer to dilute the base oligomers and/or polymers. Radical initiator with 10hr T_{½} equal to or less than 80°C provides snap cures at low temperature with long worklife. While any initiator with10hr T_{½} equal to or less than 80°C may be used, it is preferable to utilize diacryl peroxide, peroxydicarbonate, and peroxyester-type initiators. The preferred range of the thermal initiators is 0.1-10wt%. A more preferred range is 1-4wt%. Although various (meth)acrylate or vinylene-containing base oligomers and/or polymers may be utilized as the base, it is preferable to utilize urethane acrylate as the base oligomer. The preferred range of the base oligomer/polymer is 1-90wt%. A more preferred range is 10-60%. The (meth)acrylate monomer is used to dilute the base oligomers and/or polymers and react during the curing process to form in the polymer matrix. Depending upon the (meth)acrylate used, the cured materials may have additional characteristics, e.g. adhesion, high cross link density, hydrophobic, or hydrophilic properties. The preferred range of the (meth)acrylate monomer is 0.1-99wt%. A more preferred range is 20-70wt%.

The composition may further comprise of one or more non-reactive chemical compounds. These compounds do not chemically react during the curing process but may enhance other functions. The preferred range of the non-reactive chemical is 0.01-50%; a more preferred range is 0.01-10wt%.

A thixotropic agent may be added to modify the rheologic behavior of the material. The rheology of the material may be adjusted to allow high speed dispensing or printing. The preferred range of thixotropic agent is 0.1-20wt%; a more preferred range is 5-15wt%. A pigment may be added to enhance the color of the formulation. The preferred range is 0.1-10wt%; a more preferred range is 0.1-3wt%.

The material may further comprise of conductive and non-conductive fillers. Examples of conductive fillers include silver, nickel, gold, aluminum, copper, metal oxides, boron nitride, aluminum oxide, silver plated aluminum, silver plated glass, silver flakes, carbon black, graphite, boron nitride-coated particles, gold coated nickel, polymer coated fillers, and mixtures thereof. Examples of non-conductive fillers are silica, mica, talc, or hollow glass beads, zinc oxide, magnesium oxide. The preferred range of fillers is 0.01-99wt%.

The cure reaction time is affected by the onset and offset temperatures. The cure reaction time decreases as the difference of the onset and the offset temperatures is narrowed. Conversely, as the onset and the offset temperatures are broadened, the longer the cure reaction time. The worklife decreases as the onset temperature draws closer to room temperature. The worklife can also decrease as the material prematurely cures before the onset temperature.

The invention is further illustrated by the following non-limiting examples.

**TABLE 1. FORMULATIONS**

| | | A | X | Y | B | C |
|---|---|---|---|---|---|---|
| resin | Base oligomer/polymer | 35%¹ | | | 35%¹ | 35%¹ |
| | Epoxy monomer | | 90.0%⁵ | 82.9%⁵ | | |
| | Meth(acrylate monomer) | 48%² | | | 48%² | 33%² |
| | | 15%³ | | | 15%³ | 20%¹¹ |
| | | | | | | 10%¹² |
| Initiator/h ardener | | 2%⁴ | 3.6%⁶ | 12.1%⁸ | 2%¹⁰ | 2%⁴ |
| | | | 7.4%⁷ | 5.0%⁹ | | |

| | | | | | | |
|---|---|---|---|---|---|---|
| ¹Ebecryl 880 - urethane acrylate oligomer/polymer from UCB | | | | | | |
| ²Isobornylacrylate from UCB | | | | | | |
| ³SR-833S - tricyclodecane dimethanol diacrylate from SARTOMER | | | | | | |
| ⁴Luperox 10 from ATOFINA | | | | | | |
| ⁵Bis A-epoxy (Epon 862) from Shell | | | | | | |
| ⁶DICY-dicyandiamide from Degussa | | | | | | |
| ⁷Urea hardener - Omicure 35M from CVC Speciality Chemicals | | | | | | |
| ⁸Amine hardener-Ajicure PN-H from Ajinomoto | | | | | | |
| ⁹Imidazole hardener - Imicure EMI-24 from Air products | | | | | | |
| ¹⁰USP90MD from WITCO | | | | | | |
| ¹¹N, N-dimethylacrylamide from Aceto Corporation | | | | | | |
| ¹²SR285 - Tetrahydrofurfuryl acrylate from SARTOMER | | | | | | |

**TABLE 2. DSC AND WORKLIFE DATA**

| | A | X | Y | B | C |
|---|---|---|---|---|---|
| DSC FIG. | 1 | 2 | 3 | 4 | 5 |
| Peak T (°C) | 83.73 | 152.25 | 125.70 | 126.20 | 66.08 |
| Onset T (°C) | 74.10 | 94.01 | 89.98 | 97.80 | 43.06 |
| Offset cure T (°C) | 87.37 | 85.01 | 152.30 | 183.11 | 128.37 |
| Cure time at 120°C | 15 sec | 20 min | 8 min | > 60 sec | > 15 sec |
| Worklife at 25°C | 3 days | 1 week | 24 hours | 3 days | 8 hours |

### EXAMPLE 1

Three adhesive formulations were made; (A) snap-curable acrylate system, (X) typical epoxy system, and (Y) fast curing epoxy systems. The components for each formulation are summarized in Table 1. The Formulation A comprises a base polymer of urethane acrylate oligomer, isobornylacrylate, SR-833S, and Luperox 10. The Formulations X and Y are both bisphenol-A epoxy resin with different hardeners. Formulation X is a typical epoxy-based formulation that uses two hardeners, dicyandiamide (DICY) and a urea hardener. Formulation Y is a fast curing epoxy formulation that uses a combination of amine and imidazole. Materials in each formulation were combined and mixed thoroughly to achieve a homogenous mixture.

Each formulation was then tested in the Dynamic Scanning Calorimeter (DSC) to monitor the curing profile. Each DSC scan was performed from room temperature (25°C) to 300°C at a ramp speed of 10°/min. The relevant data for the formulations are summarized in Table 2. The peak, onset, and offset cure temperatures were derived from the DSC curves. Figure 1 shows that a sharp onset and offset temperatures for the cure reaction of Formulation A. The peak width is a narrow and sharp, indicating a very fast and short cure time. Figures 2 and 3 show much broader peak widths than Figure 1, and hence the cure reactions are slower for epoxy-based materials.

The cure behavior was also studied by isothermal DSC experiments at 120°C. While the temperature was maintained at 120°C, the level of exothermic reaction was monitored to determine the length of the cure time. The time it takes for the exotherm level to decrease to zero was determined as the length of time it takes for the material to fully cure. Formulation A cured in 15 seconds at 120°C. Because this material can fully cure in under 60 seconds, it can snap cure. Formulation X and Y required much longer time period, 20 and 8 minutes, respectively, to completely cure.

The worklife describes the unchanged viscosity of the formulation while storing in room temperature condition. The data in Table 2 indicates that the worklife for Formulation A was 3 days. Even thought this material can snap cure, it can maintain the same viscosity for 3 days in room temperature condition. A typical epoxy formulation can maintain 1 week of worklife, however, the length of time it takes to fully cure is 20 minutes. The fast curing epoxy formulation reacts faster than the typical epoxy, but the worklife is only 24 hours. Hence, the snap cure material is superior to both the typical and fast curing epoxy materials.

The shape of the cure profile is also related to the worklife at room temperature. It is well known in the art that typical epoxy formulations can react slowly at room temperature, and hence decrease the worklife of the material over time. Figure 2 and 3 show a slow, gradual increase in the curing curve before the sharp increase, indicating premature polymerization. In contrast, Figure 1 shows a flat profile before the sharp onset point, indicating no premature polymerization.

### EXAMPLE 2

For Formulation B, only the radical initiator was changed from Formulation A. Formulation A utilized a radical initiator Luperox 10 with 10 hour T_{½} of 48°C, and Formulation B used a higher ten hour half life initiator of 90°C, USP90MD. Materials in each formulation were combined and mixed thoroughly to achieve a homogenous mixture. The components are summarized in Table 1, and relevant data is summarized in Table 2.

Utilizing a higher half-life radical initiator resulted in longer cure reaction time, higher onset, peak, and offset temperatures. This is evidence in Figure 4. Only the worklife at 25°C remained similar to Formulation A. As the half life increases, the material no longer snap cures and the DSC curve mimics a typical epoxy based formulation.

### EXMAPLE 3

The reactivity of the resin system can influences worklife. For Formulation C, different acrylates were utilized than Formulation A. The components are summarized in Table 1. Materials were combined and mixed thoroughly to achieve a homogenous mixture. Relevant data is summarized in Table 2.

Utilizing different acrylate system can also affect the cure time. A more significant change, however, is the worklife. Changing the acrylates decreased the worklife from 3 days to 8 hours, compared to Formulation A. Figure 5 showed the change in acrylates results in lower onset and peak temperatures than Figure 1. Unlike Figure 1, there is a slight upward slope before the onset point for Figure 3. This indicates that some premature curing occurs for Formulation C. Hence, the worklife at room temperature is decreased for Formulation C as compared to A.

Many modifications and variations of this invention can be made without departing from its sprit and scope, as will be apparent to those skilled in the art. The specific embodiments described herein are offered by way of examples only, and the invention is to be limited only by the terms of the appended claims, along with the full scope and equivalents to which such claims are entitled.

## Claims

1. Acrylic adhesive composition comprising:
(a) a radical initiator with ten-hour-half-life equal to or less than 80°C;
(b) a vinylene-containing oligomer; and
(c) at least one diluent,
wherein the composition can snap cure at low temperature with at least 24 hour worklife at room temperature.

2. The composition of claim 1, wherein the radical initiator with ten-hour-half-life is selected from the group comprising diacryl peroxide, peroxydicarbonate, and peroxyester-type initiators.

3. The composition of claim 1, wherein the vinylene-containing oligomers is a urethane acrylate or epoxy acrylate.

4. The composition of claim 1, wherein the diluent is a (meth)acrylate monomer.

5. The composition of claim 2, wherein the radical initiator comprises in the range of about 0.1 wt % to 10 wt % of the total compound admixture.

6. The composition of claim 5, wherein the radical initiator comprises in the range of about 1 wt % to 4 wt % of the total compound admixture.

7. The composition of claim 3, wherein the vinylene-containing oligomers comprises in the range of about 1 wt % to 90 wt % of the total compound admixture.

8. The composition of claim 7, wherein the vinylene-containing oligomers comprises in the range of about 10 wt % to 60 wt % of the total compound admixture.

9. The composition of claim 4, wherein the diluent comprises in the range of about 0.1 wt % to 99 wt % of the total compound admixture.

10. The composition of claim 9, wherein the diluent comprises in the range of about 20 wt % to 70 wt % of the total compound admixture.

11. The composition of claim 1, further comprising one or more of the group comprising of non-reactive chemical.

12. The composition of claim 11, wherein the non-reactive chemical to enhance viscosity comprises in the range of about 0.01 wt % to 50 wt % of the total compound admixture.

13. The composition of claim 1, further comprising one or more of the group comprising of pigment.

14. The composition of claim 13, wherein the pigment comprises in the range of about 0.1 wt % to 10 wt % of the total compound admixture.

15. The composition of claim 14, wherein the pigment comprises in the range of about 0.1 wt % to 3 wt % of the total compound admixture.

16. The composition of claim 1, further comprising of fillers.

17. The composition of claim 16, wherein the filler is selected from the group comprising silver, nickel, gold, aluminum, copper, metal oxides, boron nitride, aluminum oxide, silver plated aluminum, silver plated glass, silver flakes, carbon black, graphite, boron nitride-coated particles, gold coated nickel, polymer coated fillers, silica, mica, talc, or hollow glass beads, zinc oxide, magnesium oxide, or mixtures thereof.

18. The composition of claim 16, wherein the filler comprises in the range of about 0.01 wt % to 99 wt % of the total compound admixture.

19. The composition of claim 1, wherein the adhesive is applied to electronic devices.

20. The method of claim 19, wherein the adhesive is applied to the electronic device via stencil, screen-print, ink-jet print, spin-coat, or syringe.
